# EUROPÄISCHE PATENTSCHRIFT

(11) **EP 0 645 889 B1**
(45) Veröffentlichungstag und Bekanntmachung des Hinweises auf die Patenterteilung: **12.12.2001**
(21) Anmeldenummer: 93114688.0
(22) Anmeldetag: 13.09.1993
(51) Int. Cl.: H03K 17/16

(54) **Verfahren und Vorrichtung zur Begrenzung der Stromfallgeschwindigkeit beim Ausschalten von Leistungshalbleiterschaltern mit MOS-Steuereingang**
Method and device for limiting the rate of current decrease at swith-off of semiconductor power switches with MOS control imput
Procédé et dispositif servant à limiter le taux de décroissance des courant lors du blocage de commutateurs semi-conducteurs de puissance à entrée de commande MO

(43) Veröffentlichungstag der Anmeldung: 29.03.1995
(73) Patentinhaber: SIEMENS AKTIENGESELLSCHAFT, 80333 München (DE)
(72) Erfinder: Bergmann, Martin, Dipl.-Ing., D-91091 Grossenseebach (DE); Gayer, Manfred, Dipl.-Ing., D-91334 Hemhofen (DE); Hoge, Andreas, Dipl.-Ing., D-91056 Erlangen (DE)

(56) Entgegenhaltungen:
- EP-A- 0 287 166
- EP-A- 0 340 918
- US-A- 4 639 823
- US-A- 5 204 563

## Beschreibung

Die Erfindung bezieht sich auf ein Verfahren und eine Vorrichtung zur Begrenzung der Stromfallgeschwindigkeit beim Abschalten von Leistungshalbleiterschaltern mit MOS-Steuereingang.

Leistungshalbleiterschalter mit MOS-Steuereingang (Leistungs-MOSFET und Insulated-Gate-Bipolar-Transistor (IGBT) die als gemeinsames Merkmal einen rein kapazitiv wirkenden Steuereingang (Gate-Source oder Gate-Emitter) besitzen, werden bevorzugt in Stromrichtergeräten, beispielsweise drehzahlgeregelte Antriebe und unterbrechnungsfreie Stromversorgungsanlagen, eingesetzt. Diese Bauelemente ermöglichen hohe Schaltfrequenzen und erfordern nur sehr geringe Steuerleistungen, da zum Schalten nur die Eingangskapazität umgeladen wird. Wenigstens zwei Leistungshalbleiterschalter bilden ein Phasenmodul, das mittels einer Zwischenkreisverschienung mit einer Zwischenkreiskondensatorbatterie verbunden ist. Außerdem ist jeder Leistungshalbleiterschalter mit einer Ansteuereinrichtung verbunden.

Bei Leistungshalbleiterschaltern mit MOS-Steuereingang geht die Entwicklung immer mehr in Richtung hoher Stromtragfähigkeit der Module. Zur Zeit sind Hochstrommodule erhältlich, die einen Drain-Sourcestrom von 1200 A führen können. Mit dem Ansteigen der Stromtragfähigkeit, beispielsweise von 300 A auf 600 A bzw. 600 A auf 1200 A pro Modul, stieg auch der Wert der Stromänderungsgeschwindigkeit (di/dt), insbesondere beim Ausschalten des Moduls, erheblich an. Da die Module jeweils mit einer Ansteuereinrichtung und einem Zwischenkreis elektrisch leitend verbunden sind, verursachen bei Schaltvorgängen Induktivitäten im Leistungsteil von Stromrichtern meist energiereiche Überspannungen, die je nach Höhe und Dauer zur Beschädigung elektrischer Bauteile führen können. Vor allem die relativ schnell schaltenden IGBT-Module selbst sind dabei gefährdet.

Zum Schutz gegen solche Überspannungen ist es vorteilhaft, zunächst die parasitären Induktivitäten im Hauptstromkreis durch günstige Leitungsführung zu minimieren. Sodann werden verschiedenartige Beschaltungsnetze genutzt und auf kürzester Strecke verbunden. Diesen kommt außerdem die Aufgabe zu, den Betrieb im erlaubten Arbeitsbereich für den Abschaltvorgang "RBSOA" zu gewährleisten sowie mitunter auch die Abschaltverlustleistung herabzusetzen.

Aus der EP 0 519 305 A2 ist eine Stromrichterbaueinheit bekannt, die Halbleiter-Leistungsmoduln, Kühlkörper sowie die für einen Stromrichter notwendigen Funktionselemente zu einer selbsttragenden stabilen Einheit mit hoher Packungsdichte verbindet. Durch die Anordnung der Leiterplatte, wodurch die elektrischen Funktionselemente in den von den Halbleiter-Leistungsmoduln gebildeten Raum hineinragen, entsteht eine Ebene, auf der weitere Funktionselemente, beispielsweise eine Zwischenkreis-Kondensatorbatterie, auf kürzestem Wege angebracht werden können. Außerdem sind so die Halbleiter-Leistungsmoduln auf kürzestem Wege mit ihren zugehörigen Ansteuerschaltungen verbunden. Durch diese Verbindungen auf kürzestem Wege erhält man einen sehr induktivitätsarmen Aufbau eines Stromrichters.

Aus dem Deutschen Gebrauchsmuster 89 09 246 ist eine induktionsarme Kondensatorbatterie bekannt, bei der als Tragplatte ein Stapel aus Metallplatten und flächenmäßig größeren Kunststoffplatten vorgesehen ist, wobei jeweils zwischen zwei Metallplatten eine Kunststoffplatte angeordnet ist. Durch die Verwendung eines Stapels aus Metallplatten und Kunststoffplatten, wobei die Metallplatten gleichzeitig als Stromschienen dienen, erhält man eine niederinduktive Zwischenkreisverschienung und eine induktivitätsarme Kondensatorbatterie. Außerdem kann diese Kondensatorbatterie auf kürzestem Weg mit den Halbleiter-Leistungsmoduln verbunden werden.

Zur Reduzierung von Überspannungen werden außerdem verschiedenartige Beschaltungsnetze genutzt, die auf kürzestem Wege mit den Halbleiter-Leistungsmoduln verbunden werden. Beispiele von verschiedenartigen Beschaltungsnetzen, auch Klemmbeschaltungen genannt, sind z.B. in der DE-Zeitschrift "etz", Band 110 (1989), Heft 10, Seiten 464 bis 470 dargestellt.

Die einfachste Klemmbeschaltung ist die RCD-Einzelbeschaltung, die aus einem Kondensator besteht, der in Reihe zu einer Diode mit parallelem Widerstand liegt. Beim Abschalten eines IGBT fließt der Hauptstrom zunächst durch die Diode und lädt den Kondensator. Dessen Spannung ist nahezu identisch mit der Kollektor-Emitterspannung des IGBT und nimmt zeitabhängig solange zu, bis die zugehörige Freilaufdiode im Lastkreis leitend wird. Die im Kondensator gespeicherte Energie wird beim nächsten Einschalten über den Beschaltungswiderstand abgebaut. Weil bei höherer Impulsfrequenz die am Beschaltungswiderstand in Wärme umgesetzte Verlustleistung beachtliche Werte annimmt, sind aufwendige Beschaltungsnetze bekannt, die ein nutzbringendes Rückführen der Energie aus dem Kondensator ermöglicht. Häufiger werden bei Seriengeräten kostengünstigere Maßnahmen angewendet, wie RCD-Spannungsbegrenzer für Zweigpaare oder die Summenbeschaltung auf der Gleichstromseite, die außerdem weniger Verlustleistung verursachen.

Damit RCD-Klemmbeschaltungen bei Hochstrommodule mit hoher Stromtragfähigkeit und einem hohen Stromänderungswert wirken können, muß eine sehr schnelle Diode verwendet werden, wodurch sich das Beschaltungsnetz verteuert.

Aus der Zeitschrift "Bull. ASE/UCS", 77(1986), 16, 23. August, Seiten 1030 bis 1033 ist eine Spannungsklemmbeschaltung bekannt. Diese Spannungsklemmbeschaltung besteht aus einer Reihenschaltung einer Zenerdiode und einer Diode, die zwischen einen Hauptanschluß (Kollektor, Drain) und dem Steueranschluß (Gate, Basis) eines Leistungshalbleiterschalters mit MOS-Steuereingang angeordnet ist. Verwendet man eine derartige Spannungsklemmbeschaltung so wird die Zenerspannung der Zener-Diode auf die maximale Nennspannung des Schalttransistors dimensioniert.

Ist die von der Aufbauinduktivität verursachte Spannungsspitze größer als die Zener-Spannung, so kann ein Strom über die Zener-Diode zum Steueranschluß des Leistungshalbleiterschalters - in der Folge kurz mit LHL bezeichnet - fließen und diesen leitend steuern. Dies geschieht in idealer Weise aber nur bis zu einem gewissen Grad, so daß der LHL gerade soweit aufgesteuert wird, daß die Spannung an einen Hauptpfad (Kollektor-Emitter oder Drain-Source oder Kollektor-Source, je nach Bauelementtyp) so lange immer genau der Zener-Spannung entspricht, bis der Stromfluß im Hauptpfad beendet ist und die Aufbauinduktivität die gespeichte Energie vollständig an den LHL abgegeben hat.

Bei dieser sogenannten active-clamp-Schaltung wird in Abhängigkeit der Kollektor-Emitterspannung die Gate-Emitterspannung so geregelt, daß die negative Stromsteilheit begrenzt wird. Diese Regelung ist totzeitbehaftet und benötigt eine aufwendige Erfassung der Kollektor-Emitterspannung. Außerdem entstehen bei periodischem Betrieb hohe Abschaltverluste im Leistungshalbleiter.

Wie eingangs bereits erwähnt, verursachen bei Schaltvorgängen Induktivitäten im Leistungsteil von Stromrichtern meist energiereiche Überspannungen. Diese Überspannungen sind trotz der Induktivitätsminimierung und der bekannten Beschaltungsnetze bei Hochstrommoduln mit einer hohen Stromsteilheit nicht mehr preiswert zu beherrschen, da die Ursache für derartige Überspannungen trotz minimaler Induktivität die hohe Stromsteilheit beim Schaltvorgang ist.

Der Erfindung liegt nun die Aufgabe zugrunde, ein Verfahren und eine Vorrichtung zur Begrenzung der Stromänderungsgeschwindigkeit beim Abschalten von Leistungshalbleiterschaltern mit MOS-Steuereingang anzugeben.

Diese Aufgabe wird erfindungsgemäß gelöst durch die Merkmale der unabhängigen Ansprüche 1 bzw. 2.

Durch das erfindungsgemäße Verfahren wird beim Abschalten des Leistungshalbleiterschalters die Gate-Emitterspannung durch eine Gegenkopplung einer Gegenspannung, die in Abhängigkeit einer Induktivität erzeugt wird, derart geregelt, daß die Stromfallgeschwindigkeit des Leistungshalbleiterschalters reduziert wird. Durch die Reduzierung der Stromfallgeschwindigkeit (negative Stromsteilheit) wird ebenfalls der Wert der Überspannung reduziert. Die Begrenzung der negativen Stromsteilheit kann unter Umständen die RCD-Klemmbeschaltung überflüssig machen bzw. die Wirksamkeit vorhandener RCD-Klemmbeschaltungen wesentlich erhöhen.

Die Vorteile dieses erfindungsgemäßen Verfahren bestehen darin, daß die Abschaltgeschwindigkeit wirksam reduziert werden kann, ohne dabei die Speicherzeit zu vergrößern. Die Gegenkopplung wirkt unverzögert und ist insbesondere beim Auftreten von sehr hohen negativen Stromsteilheiten, beispielsweise bei Überstrom bzw. Kurzschlußstrom, verstärkt wirksam. Der Wert der Stromänderungsgeschwindigkeit, der mittels des erfindungsgemäßen Verfahrens einstellbar ist, ist unabhängig vom Nennbetrieb oder Kurzschlußbetrieb. Somit kann auch auf eine active-clamp-Schaltung parallel zu einer RCD-Klemmbeschaltung verzichtet werden. Außerdem wird das Einschaltverhalten nicht beeinflußt und die Größe der Gegenkopplung ist einstellbar, wodurch die Stromänderungsgeschwindigkeit definiert werden kann.

Vorteilhafte Ausführungsformen der Vorrichtung zur Durchführung des erfindungsgemäßen Verfahrens sind durch die Merkmale der weiteren unabhänigen Ansprüche 3 und 4 gekennzeichnet.

Zur weiteren Erläuterung der Erfindung wird auf die Zeichnung Bezug genommen, in der mehrere Ausführungsbeispiele der Vorrichtung zur Durchführung des erfindungsgemäßen Verfahren schematisch veranschaulicht sind.
- FIG 1: zeigt einen Leistungshalbleiterschalter mit MOS-Steuereingang und einer bekannten Ansteuereinrichtung, in
- FIG 2: ist ein erstes Ausführungsbeispiel der Vorrichtung nach der Erfindung dargestellt, wobei in den
- FIG 3 und 4: jeweils ein vorteilhaftes Ausführungsbeispiel der Vorrichtung nach der Erfindung dargestellt sind, die
- FIG 5, 7 und 9: zeigen jeweils in einem Diagramm über der Zeit t den Laststromverlauf bzw. die Gate-Emitterspannung bzw. die Kollektor-Emitterspannung des Leistungshalbleiterschalters mit herkömmlicher Ansteuereinrichtung, wogegen in den
- FIG 6,8 und 10: die jeweiligen Verläufe einer Vorrichtung nach der Erfindung jeweils in einem Diagramm über der Zeit t veranschaulicht sind.

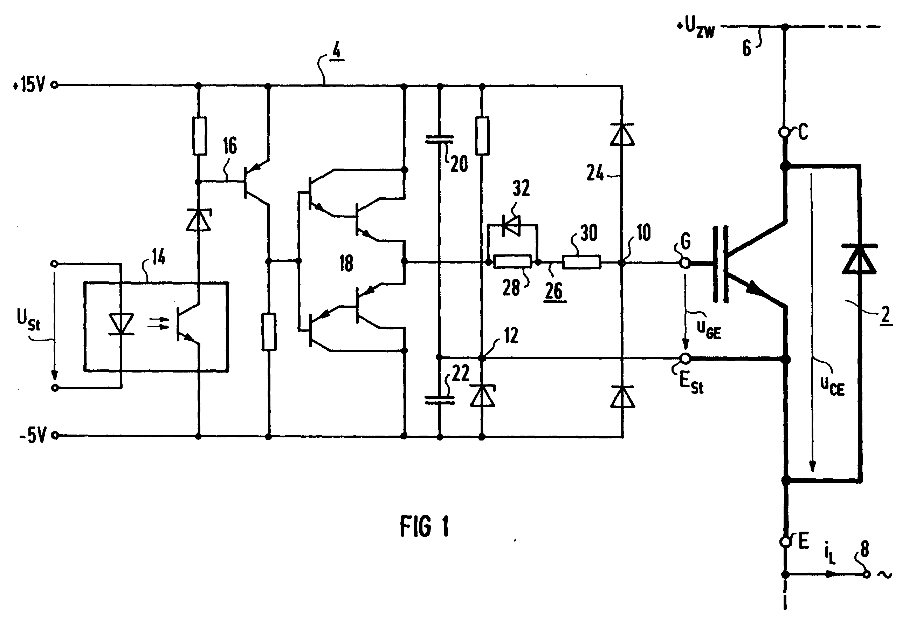

Die Figur 1 zeigt einen Leistungshalbleiterschalter 2 mit einem MOS-Steuereingang G, beispielsweise ein MOS-FET-Hochstrommodul oder ein IGBT-Hochstrommodul, mit einer herkömmlichen Ansteuereinrichtung 4. Das Hochstrommodul 2 ist zur besseren Kennzeichnung mit einer breiteren Strichstärke gezeichnet. Das Hochstrommodul 2 ist mit seinem Kollektor-Leistunganschluß C an eine positive Zwischenkreisschiene 6 angeschlossen, die eine positive Zwischenkreisspannung +U_{ZW} führt. Der Emitter-Leistungsanschluß E ist einerseits mit einem Wechselstromanschluß 8 und andererseits mit einem Kollektor-Leistungsanschluß eines weiteren Hochstrommoduls mit einer Ansteuereinrichtung verknüpft, die aus Übersichtlichkeitsgründen nicht näher dargestellt sind. Die Ansteuereinrichtung 4 ist mit seinen beiden Ausgängen 10 und 12 mit den Steuereingängen G und E_{St} des Leistungshalbleiterschalters 2 verbunden.

Die Ansteuereinrichtung 4 ist aus der Veröffentlichung "Application of parallel-connected IGBT's in frequency converters in the medium power range" abgedruckt in "Power conversion", June 1991 Proceedings, Seiten 490 bis 501, bekannt und besteht aus einem Optokoppler 14, einer Verstärkerstufe 16, einer Gegentakt-Treiberstufe 18, einer positiven und negativen Leerlaufspannungsquelle 20 und 22, einer Begrenzungsschaltung 24 und eines Steuerkreiswiderstandes 26. Der Steuerkreiswiderstand 26 besteht aus einem On-Widerstand 28 und einem Off-Widerstand 30, wobei der On-Widerstand 28 mit einer parallelen Diode 32, die antiparallel zum Steuerstrom geschaltet ist, versehen ist. Aufbau dieses Steuerkreiswiderstandes 26 ist bekannt aus "IEEE IAS 1982 Conference Record", 1982 Seiten 939 bis 944. Außerdem sind in der eingangs genannten DE-Zeitschrift"etz", Band 110 (1989), Heft 10, Seiten 464 bis 470, weitere Prinzipschaltungen von Treiberendstufen für IGBT dargestellt.

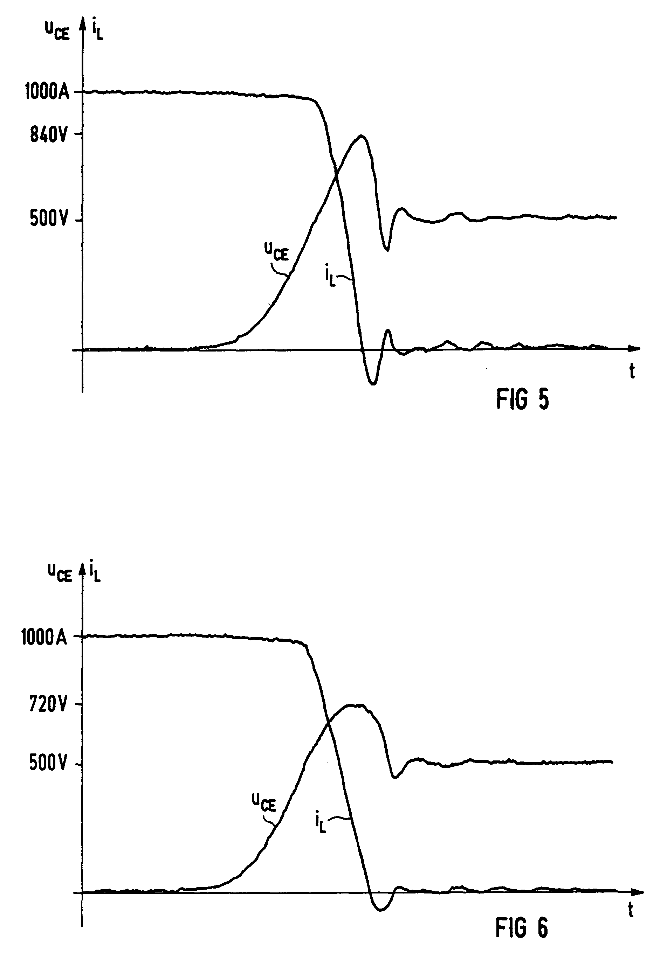

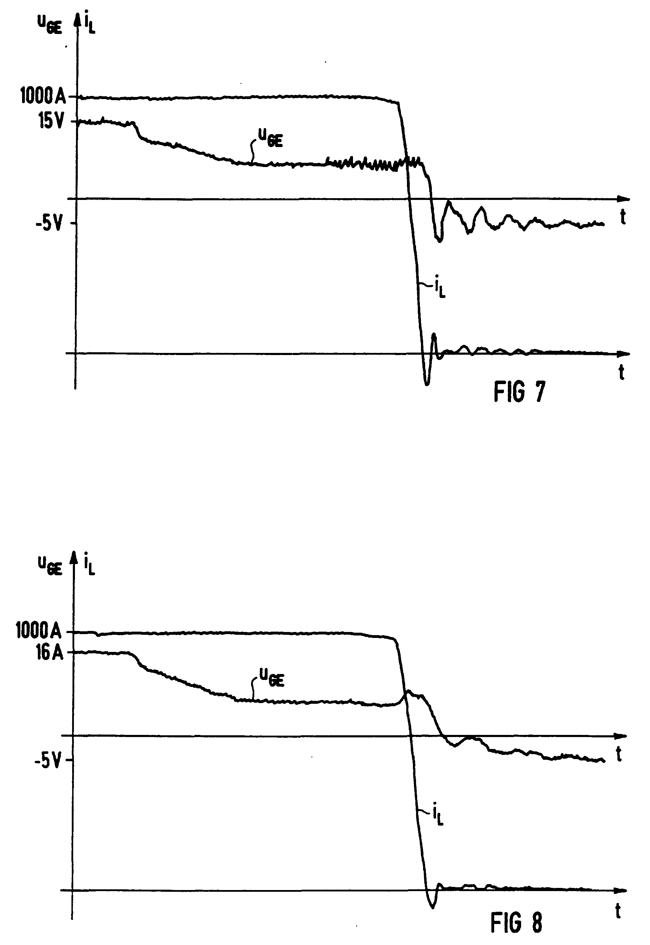

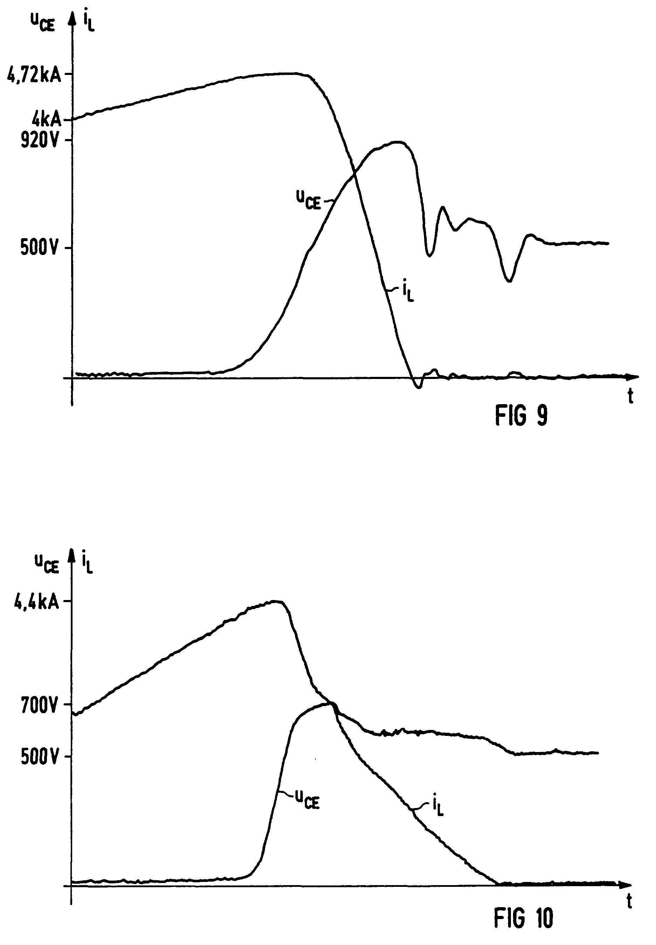

Die Signalverläufe von Laststrom i_{L}, von der Gate-Emitterspannung u_{GE} und von der Kollektor-Emitterspannung u_{CE} beim normalen Ausschalten sind in den Figuren 5 und 7 jeweils in einem Diagramm über der Zeit t dargestellt. Die Signalverläufe von Laststrom i_{L} und Kollektor-Emitterspannung u_{CE} beim Ausschalten im Kurzschlußfall sind in der Figur 9 in einem Diagramm über Zeit t dargestellt. Als positive Zwischenkreisspannung +U_{ZW} wurde +U_{ZW} = 500 V gewählt. Ohne das erfindungsgemäße Verfahren steigt die Kollektor-Emitterspannung u_{CE} auf ungefähr 840 V und die negative Stromsteilheit beträgt 7,7 kA/µs. Im Kurzschlußfall steigt die Kollektor-Emitterspannung u_{CE} auf ungefähr 920 V an.

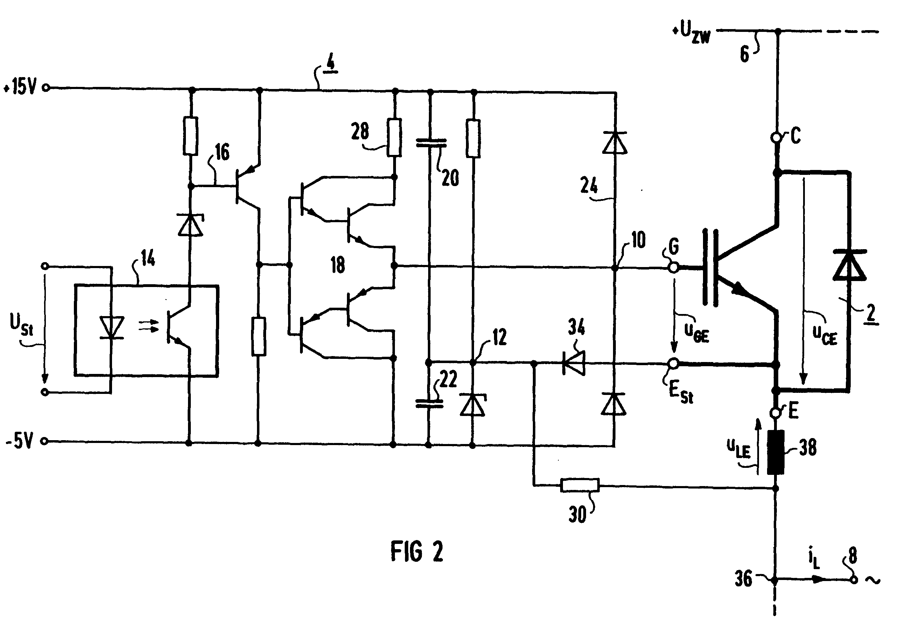

Die Figur 2 zeigt eine erste Ausführungsform der Vorrichtung zur Durchführung des erfindungsgemäßen Verfahrens zur Begrenzung der Stromfallgeschwindigkeit beim Abschalten von einem Leistungshalbleiterschalter 2 mit MOS-Steuereingang G. Der Unterschied zur Ausführungsform gemäß Figur 1 besteht darin, daß der zweite Ausgang 12 der Ansteuereinrichtung 4 einerseits mittels einer Entkopplungsdiode 34 mit dem Steueranschluß E_{St} des Hochstrommoduls 2 und andererseits über den Off-Widerstand 30 mit einem Verzweigungspunkt 36 verbunden ist, wobei am Verzweigungspunkt 36 der Wechselstromanschluß 8 und ein weiteres nicht näher dargestelltes Hochstrommodul einer Brückenzweigschaltung einer mehrpulsigen Stromrichterschaltung angeschlossen sind. Der Verzweigungspunkt 36 ist über eine Induktivität 38 mit dem Emitter-Leistungsanschluß E des Hochstrommoduls 2 verknüpft. Beim Einschalten wird mittels der Entkopplungsdiode 34 die Induktivität 38 für den Steuerstrom überbrückt, so daß die Gate-Emitterspannung u_{GE} an den Steueranschlüssen G und E_{St} des Hochstrommoduls 2 nicht beeinflußt wird. Beim Ausschalten koppelt die Entkopplungsdiode 34 den Verzweigungspunkt 36 vom Steueranschluß E_{St} des Hochstrommoduls 2 ab, so daß die in Abhängigkeit von der Stromanstiegsgeschwindigkeit beim Ausschalten erzeugte Gegenspannung u_{LE} der Gate-Emitterspannung u_{GE} entgegenwirken kann.

Als Induktivität 38 kann eine Leiterschleife oder ein Teilstück einer stromdurchflossenen Stromschiene dienen. Durch diese Ausführungsform befindet sich die Induktivität 38 einerseits im Hochstrompfad und andererseits im Ausschaltsteuerkreis. Dadurch wird die durch die Stromfallgeschwindigkeit -di_{L}/dt und der Induktivität 38 erzeugte Gegenspannung u_{LE} derart auf die Gate-Emitterspannung u_{GE} gegengekoppelt, daß diese konstant gehalten bzw. angehoben wird. Durch dieses Einwirken der Gegenspannung u_{LE} auf die Gate-Emitterspannung u_{GE} wird die Stromfallgeschwindigkeit - di_{L}/dt reduziert.

Im Diagramm gemäß Figur 8 ist die Anhebung der Gate-Emitterspannung u_{GE} zu sehen, die erst mit dem fallenden Strom i_{L} aufgebaut wird. Mit Entstehung der Gegenspannung u_{LE} und damit die Regelung der Gate-Emitterspannung u_{GE} verändert sich die negative Stromsteilheit-di_{L}/dt derart, daß sich ihr Wert reduziert. In der Figur 6 sind die zugehörigen Signalverläufe von Laststrom i_{L} und Kollektor-Emitterspannung u_{CE} in einem Diagramm über der Zeit t dargestellt. Dieser Figur 6 ist zu entnehmen, daß in Folge der Gegenkopplung (Gegenspannung u_{LE} auf Gate-Emitterspannung u_{GE} gegengekoppelt), wodurch sich die negative Stromsteilheit -di_{L}/dt reduziert, die Kollektor-Emitterspannung u_{CE} nur noch einen Wert von 720 V erreicht. Gegenüber dem Abschalten des Hochstrommoduls 2 ohne Gegenkopplung ist der Wert der Kollektor-Emitterspannung u_{CE} um ungefähr 120 Volt kleiner. Die Stromsteilheit wurde von 7,7 kA/µs auf 5,1 KAµs. reduziert.

Um unterschiedliche Gegenspannungen u_{LE} an der Induktivität 38 zu erzeugen, kann der Wert der Induktivität 38 verändert werden. Die Änderung des Wertes der Induktivität 38 ist im Hinblick auf einen niederinduktiven Aufbau eines Stromrichters nur in sehr engen Grenzen zu variieren. Die Stromsteilheit -di/dt beim Ausschalten ist bei Auftreten eines Überstrom bzw. eines Kurzschlußstroms gegenüber den Nennstrom sehr viel größer, so daß sich die erfindungsgemäße Gegenkopplung gerade bei Überstrom- bzw. Kurzschlußstrom verstärkt wirksam ist. In den Figuren 9 und 10 sind die hier interessierenden Signalverläufe beim Abschalten eines Kurzschlußstromes dargestellt, wobei die Figur 10 die Signalverläufe bei der erfindungsgemäßen Ausführungsform darstellt. Durch die erfindungsgemäße Gegenkopplung steigt die Kollektor-Emitterspannung u_{CE} des Hochstrommoduls 2 nicht mehr auf etwa 920 V, sondern nur noch auf etwa 700 V an. Ebenso verringert sich die maximale negative Stromsteilheit von 14 kA/µs auf 5,5 kA/µs.

Ein wesentlicher Vorteil des erfindungsgemäßen Verfahrens besteht darin, daß die wirksame Reduzierung der Abschaltgeschwindigkeit ohne Vergrößerung der Speicherzeit der Ansteuerung erzielt wird. Durch dieses erfindungsgemäße Verfahren kann nicht nur auf eine active-clamp-Schaltung verzichtet werden, sondern unter Umständen sogar auch auf die RCD-Beschaltung, wodurch sich der Aufwand pro Stromrichterventil verringert. Zumindest erhöht sich die Wirksamkeit vorhandener RCD-Klemmschaltungen wesentlich.

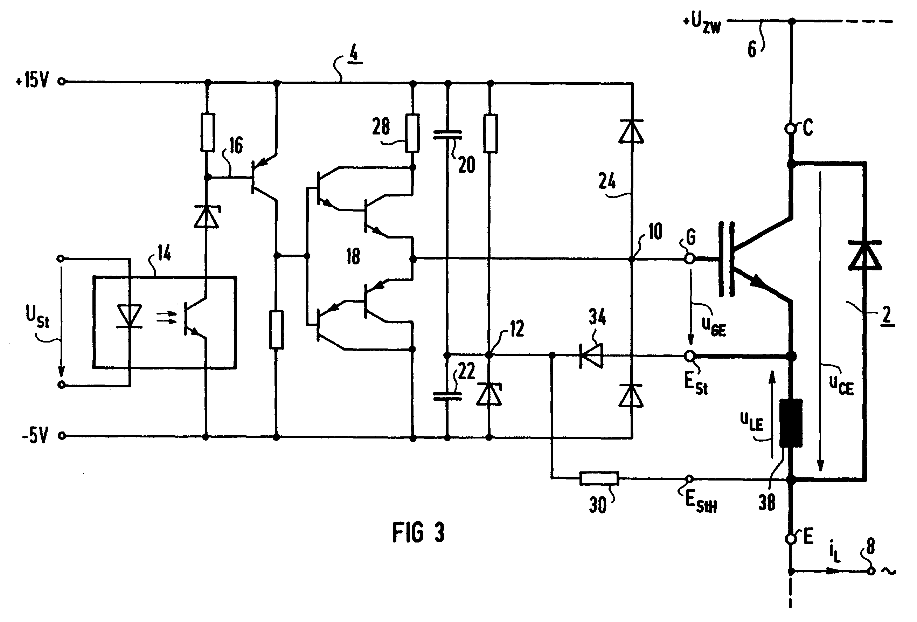

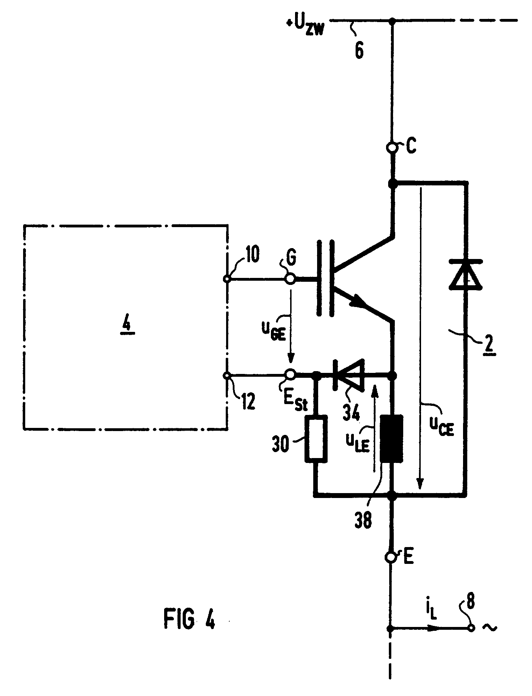

In den Figuren 3 und 4 sind vorteilhafte Ausführungsformen der Erfindung dargestellt. In Figur 3 ist die Induktivität 38 eine modulinterne Emitter-Induktivität, die durch die Bonddrähte und interne Verschienung im Modul 2 erzeugt wird. In diesem Fall wird der zweite Ausgang 12 der Ansteuereinrichtung 4 über den Off-Widerstand 30 mit dem Emitter-Leistungsanschluß E des Hochstrommoduls 2 verbunden. Falls ein Hochstrommodul 2 mit einem Hilfsemitter-Steueranschluß E_{StH} versehen ist, wird der zweite Ausgang 12 der Ansteuereinrichtung 4 einerseits über die Entkopplungsdiode 34 mit den Emitter-Steueranschluß E_{St} und andererseits über den Off-Widerstand 30 mit den Hilfsemitter-Steueranschluß E_{StH} verknüpft.

Eine besonders vorteilhafte Ausführungrform der Erfindung ist in Figur 4 dargestellt. In dieser Darstellung sind die Entkopplungsdiode 34, die Induktivität 38 und der Off-Widerstand 30 Bestandteile des Hochstrommoduls 2. Den Off-Widerstand 30 kann auch auf mehrere Widerstände aufgeteilt werden, wodurch der überwiegende Teil des Off-Widerstandes 30 in der Ansteuereinrichtung 4, beispielsweise im Kollektorzweig des unteren Transistors der Gegentakt-Treiberstufe 18, angeordnet sein kann. In dieser Ausführungsform braucht der Ausgang der Ansteuereinrichtung 4 nicht abgeändert werden.

## Patentansprüche

1. Vorrichtung zur Begrenzung einer Stromfallgeschwindigkeit (-di_{L}/dt) eines abschaltenden einen MOS-Steuereingang (G) aufweisenden Leistungshalbleiterschalters (2) mit einer Ansteuereinrichtung (4), deren erster Ausgang (10) mit diesem MOS-Steuereingang (G) und deren zweiter Ausgang (12) einerseits mittels einer Entkopplungsdiode (34) mit dem Emitter-Anschluß (E_{St}) des Leistungshalbleiterschalters (2) und andererseits über einen Widerstand (30) mit einem Lastanschluß verknüpft sind, der mittels einer Induktivität (38) mit dem Emitter-Anschluß des Leistungshalbleiterschalters (2) verbunden ist.

2. Vorrichtung zur Begrenzung einer Stromfallgeschwindigkeit (-di_{L}/dt) eines abschaltenden einen MOS-Steuereingang (G) aufweisenden Leistungshalbleiterschalters (2) mit einer Ansteuereinrichtung (4), wobei der Leistungshalbleiterschalter (2) mit einem Emitter-Anschluß (E_{St}) und einem Hilfsemitter-Steueranschluß (E_{StH}) versehen ist, zwischen denen eine modulinterne Emitterinduktivität (38) vorhanden ist und wobei der erste Ausgang (10) der Ansteuereinrichtung (4) mit dem MOS-Steuereingang (G) und sein zweiter Ausgang (12) einerseits mittels einer Entkopplungsdiode (34) mit dem Emitter-Anschluß (E_{St}) und andererseits mittels eines Widerstandes (30) mit dem Hilfsemitter-Steueranschluß (E_{StH}) des Leistungshalbleiterschalters (2) verknüpft sind.

3. Vorrichtung nach Anspruch 1, wobei die Entkopplungsdiode (34), die Induktivität (38) und der Widerstand (30) Bestandteile des Leistungshalbleiterschalters (2) sind.

## Claims

1. Device for limiting the rate of current decrease (-di_{L}/dt) of a semiconductor power switch (2) having an MOS control input (G) at switch-off, with a gating unit (4) whose first output (10) is linked to this MOS control input (G) and whose second output (12) is linked on the one hand by means of a decoupling diode (34) to the emitter terminal (E_{St}) of the semiconductor power switch (2), and on the other hand by way of a resistor (30) to a load terminal which is connected by means of an inductance (38) to the emitter terminal of the semiconductor power switch (2).

2. Device for limiting the rate of current decrease (-di_{L}/dt) of a semiconductor power switch (2) having an MOS control input (G) at switch-off, with a gating unit (4), where the semiconductor power switch (2) is provided with an emitter terminal (E_{St}) and an auxiliary emitter gate terminal (E_{StH}), between which an internal emitter inductance (38) is present in the module, and where the first output (10) of the gating unit (4) is linked to the MOS control input (G) and its second output (12) is linked on the one hand by means of a decoupling diode (34) to the emitter terminal (E_{St}), and on the other hand by way of a resistor (30) to the auxiliary emitter gate terminal (E_{StH}) of the semiconductor power switch (2).

3. Device in accordance with Claim 1, where the decoupling diode (34), the inductance (38) and the resistor (30) are components of the semiconductor power switch (2).

## Revendications

1. Dispositif pour limiter une vitesse de décroissance de courant (- di_{L}/dt) d'un commutateur semi-conducteur de puissance (2) effectuant une coupure et comportant une entrée de commande MOS (G) comprenant un dispositif de commande (4) dont la première sortie (10) est reliée à cette entrée de commande MOS (G) et dont la deuxième sortie (12) est reliée d'une part au moyen d'une diode de découplage (34) à la borne d'émetteur (E_{St}) du commutateur semi-conducteur de puissance (2) et d'autre part par l'intermédiaire d'une résistance (30) à une borne de charge qui est reliée au moyen d'une inductance (38) à la borne d'émetteur du commutateur semi-conducteur de puissance (2).

2. Dispositif pour limiter une vitesse de décroissance de courant (- di_{L}/dt) d'un commutateur semi-conducteur de puissance (2) effectuant une coupure et comportant une entrée de commande MOS (G) avec un dispositif de commande (4), dans lequel le commutateur semi-conducteur de puissance (2) est muni d'une borne d'émetteur (E_{St}) et d'une borne de commande d'émetteur auxiliaire (E_{StH}) entre lesquelles se trouve une inductance d'émetteur interne au module (38) et dans lequel la première sortie (10) du dispositif de commande (4) est reliée à l'entrée de commande MOS (G) et sa deuxième sortie (12) est reliée d'une part au moyen d'une diode de découplage (34) à la borne d'émetteur (E_{St}) et d'autre part au moyen d'une résistance (30) à la borne de commande d'émetteur auxiliaire (E_{StH}) du commutateur semi-conducteur de puissance (2).

3. Dispositif selon la revendication 1, dans lequel la diode de découplage (34), l'inductance (38) et la résistance (30) font partie du commutateur semi-conducteur de puissance (2).
